# EUROPÄISCHE PATENTSCHRIFT

(11) **EP 0 981 722 B1**
(45) Veröffentlichungstag und Bekanntmachung des Hinweises auf die Patenterteilung: **28.11.2001**
(21) Anmeldenummer: 98924040.3
(22) Anmeldetag: 26.03.1998
(51) Int. Cl.: G01D 11/30, H01R 12/16

(54) **MESSWERK**
MEASURING SYSTEM
SYSTEME DE MESURE

(30) Priorität: 14.05.1997 DE 19720196
(43) Veröffentlichungstag der Anmeldung: 01.03.2000
(73) Patentinhaber: TRW Automotive Electronics & Components GmbH & Co. KG, 78315 Radolfzell (DE)
(72) Erfinder: SAUTER, Roland, D-78056 Villingen-Schwenningen (DE)
(74) Vertreter: Eder, Thomas, Dr.-Ing.
(86) Internationale Anmeldenummer: DE9800895
(87) Internationale Veröffentlichungsnummer: WO9851998

(56) Entgegenhaltungen:
- EP-A- 0 072 502
- DE-A- 2 360 359
- DE-A- 4 405 578
- DE-A- 19 519 834
- DE-A- 19 625 060
- US-A- 3 853 382
- US-A- 5 192 228

## Beschreibung

Die Erfindung betrifft ein Messwerk mit mehreren am Außenumfang des Messwerkes angeordneten federnde Zungen und eine Anordnung des Messwerkes auf einer Trägerplatte.

Messwerke können auf verschiedene Arten mit einer Trägerplatte verbunden werden, wobei dies in der Mehrheit mittels Schrauben erfolgt. Das für diese Art von Verbindung notwendige Festschrauben mit weiteren Arbeitsgängen, wie beispielsweise Verlöten, für eine Kontaktierung, stellte sich bei der Montage jedoch als zeitaufwendig und umständlich heraus.

In der DE-A-195 19 834 wurde deshalb eine Verbindung zwischen Messwerk und Träger vorgeschlagen, bei der das Messwerk mittels eines Bajonettverschlusses schnell mit dem Träger verbunden werden kann. Eine Kontaktierung erfolgt bei dieser Verbindung über an der Außenseite des Messwerkes angeordnete federnde Zungen, die beim Festlegen des Messwerkes am Träger an ihnen zugeordneten Kontaktflächen mit Federkraft angepresst werden.

Bei dieser Art der Verbindung zwischen Messwerk und Träger ist jedoch ein unerwünschtes Verdrehen durch mechanische Einflüsse, wie beispielsweise Erschütterungen, nach der Montage möglich, so dass die Kontaktzungen und die Kontaktflächen außer Eingriff geraten. Des Weiteren kann es hierbei auch zu einem gänzlichen Lösen des Bajonettverschlusses kommen.

Zusätzlich können sich mechanische Einflüsse bei dieser Verbindung auf die nur durch Federkraft gehaltene Kontaktierung auswirken, so dass diese zumindest zeitweise verschlechtert werden kann.

Der vorliegenden Erfindung liegt daher die Aufgabe zugrunde, ein kostengünstig herstellbares Messwerk zu schaffen, das eine einfache, kostengünstige und robuste Verbindung mit einer Trägerplatte ermöglicht, sowie eine Anordnung eines derartigen Messwerkes auf einer Trägerplatte, die ein Verdrehen und/oder Lösen des Messwerkes nach der Montage verhindert.

Die Aufgabe wird erfindungsgemäß mit den Merkmalen der Ansprüche 1 und 7 gelöst.

Durch die Ausbildung von am Außenumfang des Messwerkes angeordneten federnden Zungen als Rastzungen, welche in Ausnehmungen der Trägerplatte einrastbar sind, ist ein nachträgliches unerwünschtes Verdrehen und/oder Lösen der Verbindung auf einfache Weise verhindert. Hierbei können die Rastzungen am Gehäuse angeformt, beispielsweise angespritzt, sein, so dass bei kostengünstiger Herstellung des Messwerkes bzw. dessen Gehäuses eine besonders schnelle und einfache Montage gewährleistet ist.

Die Trägerplatte kann hierbei als Leiterplatte ausgebildet sein. Die zur Kontaktierung des Messwerkes aus dessen Unterseite ragenden Kontaktstifte sind in entsprechende Kontaktausnehmungen der Trägerplatte einsetzbar. Auf diese Weise kann bei der erfindungsgemäßen Verbindung zwischen einem Messwerk und einer Trägerplatte gleichzeitig die Kontaktierung des Messwerkes gewährleistet werden.

Die elektrische Verbindung der Kontaktstifte mit den Kontaktausnehmungen erfolgt dann beispielsweise während des Verbindens durch Einpressen und/oder durch nachträgliches Verlöten.

In der bevorzugten Ausführungsform der Erfindung sind die Kontaktstifte im Querschnitt quadratisch und die entsprechenden Kontaktausnehmungen im Querschnitt rund ausgebildet, so dass kostengünstige handelsübliche Kontaktstifte und Leiterplatten verwendbar sind. In diesem Fall ergibt sich zwischen den Außenflächen der Kontaktstifte und den Innenflächen der Kontaktausnehmungen entlang der Kanten der Kontaktstifte im wesentlichen eine Linienberührung. Hierbei können als Kontaktstifte vorteilhafterweise auch die Anschlußstifte der Messspule selbst dienen.

Es sind aber auch andere Profile der Kontaktstifte sowie deren komplementäre Ausbildung der Kontaktausnehmung denkbar.

Die Enden der Kontaktstifte können hierbei verjüngt und/oder die Öffnungen der Kontaktausnehmungen trichterförmig ausgebildet sein, um ein Verbinden durch eine hieraus resultierende Selbstzentrierung beim Einsetzen zu erleichtern.

In weiterer Ausführungsform der Erfindung können die Kontaktausnehmungen als Durchbrüche mit Durchkontaktierung ausgebildet sein, wobei die Kontaktstifte, wie in jeder Ausführungsform, hierbei auch gasdicht mit den Kontaktausnehmungen verpressbar sein können. Hierdurch kann vorteilhafterweise eine gasdichte Verbindung zwischen den Berührstellen bzw. Berührflächen von Kontaktstiften und Kontaktausnehmungen ermöglicht werden. Diese Ausbildungen tragen so zu einer Verbesserung der elektrischen Verbindung zwischen den Kontaktstiften und den jeweiligen Kontaktausnehmungen bei.

Eine weitere Verbesserung dieser elektrischen Verbindung ermöglicht die Ausstattung der Kontaktausnehmungen mit einer Zinnlegierung und/oder das Verzinnen der Kontaktstifte.

Selbstverständlich kann hierfür auch eine andere Legierung oder Metall mit besonderer elektrischer Leitfähigkeit, wie beispielsweise Gold, verwendet werden.

Um bei der Montage unerwünschte mechanische Beanspruchungen an den Kontaktstiften zu verhindern, kann am Messwerk wenigstens ein Zentrierbolzen angeordnet sein, der in eine entsprechende Zentrierausnehmung in der Trägerplatte einführbar ist. Ein derartiger Zentrierbolzen kann, um sein Einführen in die Zentrierausnehmung zu erleichtern, mit einem sich verjüngenden Ende ausgebildet sein. Ebenfalls kann die entsprechende Zentrierausnehmung hierfür eine trichterförmige Öffnung aufweisen.

Selbstverständlich sind auch die Ausbildungen in ihrer jeweiligen kinematische Umkehr von der Erfindung mitumfasst.

Weitere Ausführungsformen der Erfindung ergeben sich aus den Unteransprüchen.

Die Erfindung wird nachfolgend anhand eines in der Zeichnung dargestellten Ausführungsbeispiels erläutert. In der Zeichnung zeigen:
- Fig. 1: eine Seitenansicht eines Messwerkes;
- Fig. 2: eine Unteransicht eines Messwerkes nach Fig. 1;
- Fig. 3: eine Draufsicht auf eine als Leiterplatte ausgebildete Trägerplatte;
- Fig. 4: eine vergrößerte Ausschnittansicht entlang der Linie IV-IV in Fig. 3 mit nicht eingesetztem Kontaktstift und
- Fig. 5: eine teilgebrochene Draufsicht von Fig. 4.

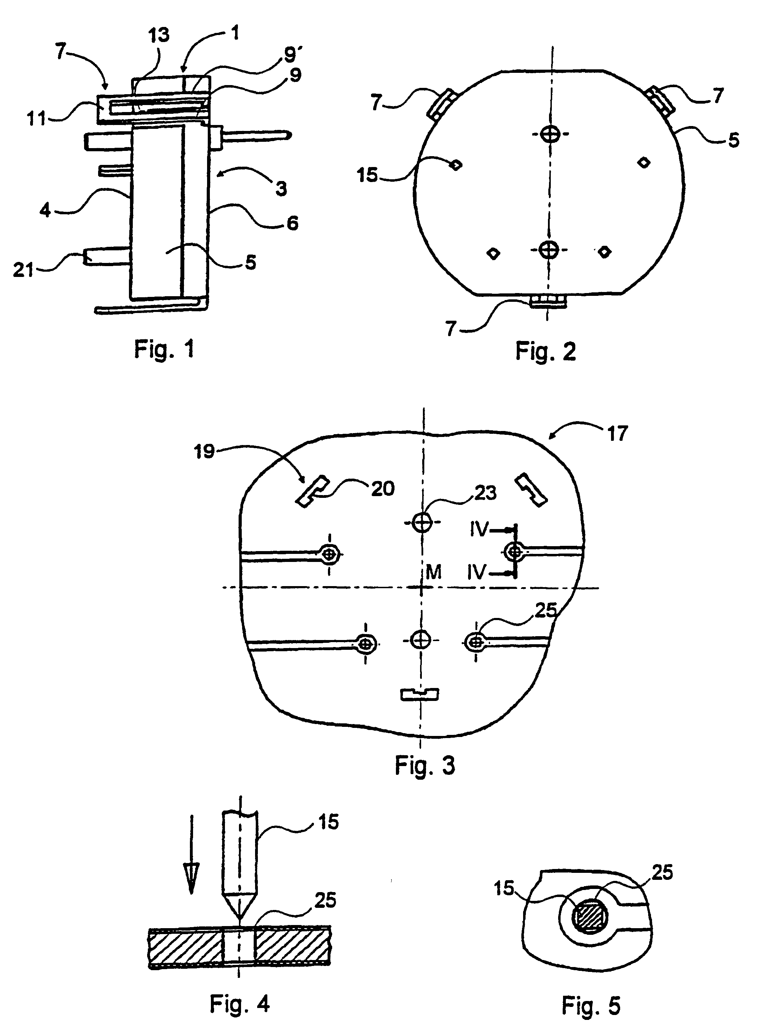

In Fig. 1 und Fig. 2 ist als Einzelteil ein Messwerk 1 dargestellt, das ein Gehäuse 3 von im Wesentlichen rundem Grundriß mit zwei sich einander gegenüberliegenden abgeflachten Seiten und konstanter Höhe umfasst.

Das Gehäuse 3 weist so im Wesentlichen die Form eines Zylinders mit Boden 4, Außenumfang 5 und Deckel 6 auf.

Am Außenumfang 5 sind gleichbeabstandet drei rechteckförmige Rastfedern 7 achsparallel zur Höhe des Gehäuses 3 angeordnet. Die Rastfedern umfassen zwei parallele voneinander beabstandete Längsseiten 9, 9', die an ihrem einen Endpunkt an dem Gehäuse 3 angeformt sind. An ihrem gegenüberliegenden freien Ende sind die beiden Längsseiten 9, 9' über einen zu ihnen rechtwinkligen Quersteg 11 verbunden, wodurch zwischen Längsseiten 9, 9' und Quersteg 11 eine rechteckförmige Ausnehmung 13 gebildet wird.

Wie in Fig. 2 ersichtlich, überragt jede Rastfeder 7 mit ihrem freien Ende die Höhe des Gehäuses 3, so dass ein Teil der rechteckförmigen Ausnehmung 13 über den Gehäuseboden 4 hinausragt.

Diese über den Gehäuseboden 4 hinausragenden Teile der rechteckförmigen Ausnehmungen 13 finden in der in Fig. 3 dargestellten Trägerplatte 17 ihre Entsprechung. Hier befinden sich in derselben Anordnung wie die der Rastfedern 7 am Gehäuseboden 4 bzw. -unterseite U-förmige Ausnehmungen 19 mit Öffnung (des "U") in Richtung des Trägerplattenmittelpunkts M.

Die U-Form der Ausnehmungen 19 wird hierbei durch eine vom Trägerplattenmittelpunkt M weg gerichtete Rastnase 20 gebildet, wobei die Ausnehmung 19 durch diese Rastnase 20 nur soweit verengt wird, dass die Rastfeder bzw. der Quersteg nach wie vor bequem einführbar ist.

Wie in Fig. 1 und Fig. 2 dargestellt ragen aus der Unterseite bzw. dem Boden 4 des Gehäuses 3 von dem nicht näher dargestellten Gehäuseinneren vier Kontaktstifte 15 mit beispielsweise rechteckigem Grundriss senkrecht hervor.

Diese Kontaktstifte 15 sind in diesem Ausführungsbeispiel spiegelsymmetrisch zur Längsachse mit unterschiedlichem Abstand zu dieser angeordnet.

Weiterhin sind auf der Längsachse voneinander beabstandet Zentrierbolzen 21 senkrecht am Gehäuseboden 4, beispielsweise angespritzt, angeordnet. Die vorteilhafterweise im Querschnitt rund ausgebildeten Zentrierbolzen 21 überragen sowohl die Kontaktstifte 15 als auch die Rastfedern 7.

Wie in Fig. 3 dargestellt, weist die Trägerplatte 17 an entsprechender Stelle zur Aufnahme der Zentrierbolzen 21 als Löcher ausgebildete, hierzu komplementäre Zentrierausnehmungen 23 auf. Weiterhin befinden sich auf der Trägerplatte 17 an entsprechender Stelle als Durchkontaktierung bzw. Bohrung ausgebildete Kontaktausnehmungen 25 mit sich daran anschließenden elektrischen Leitern zur Aufnahme der Kontaktstifte 15.

Wie in Fig. 4 dargestellt, können die Kontaktstifte 15 sich verjüngende Enden in Form von Spitzen aufweisen, um leichter in die Kontaktausnehmungen 25 eingeführt werden zu können.

Werden das Messwerk und die Trägerplatte miteinander verbunden, so kommen zuerst die Zentrierbolzen 21 mit den entsprechenden Zentrierausnehmungen 23 in Eingriff.

Ein Verfehlen der Zentrierausnehmungen 23 hat hierbei durch die die übrigen Elemente überragenden Zentrierbolzen 21 keine nachteiligen Auswirkungen, wie beispielsweise Verbiegen oder Beschädigen der Kontaktstifte 15 und/oder der Rastfedern 7.

Bei korrektem Einsetzen der Zentrierbolzen 21 in die entsprechenden Zentrierlöcher 23 erfolgt hierdurch bedingt ein positionsrichtiges Einpressen der Kontaktstifte 15 in die entsprechenden Kontaktausnehmungen 25. Gleichzeitig werden die Rastfedern 7 bzw. deren Enden positionsrichtig in die entsprechenden Ausnehmungen 19 eingeführt.

Sobald das Messwerk 1 mit seiner Unterseite des Gehäuses 3 die Oberfläche der Trägerplatte 17 berührt, rasten die Rastnasen 20 hinter den jeweiligen Stegen 11 der Rastfedern 7 ein.

Hierdurch ergibt sich eine feste Verbindung zwischen Messwerk 1 und Trägerplatte 17, die auch durch mechanische Einflüsse, wie beispielsweise Erschütterungen, nicht unerwünscht gelockert oder gelöst wird.

In dem Ausführungsbeispiel wird vorteilhafterweise gleichzeitig zur mechanischen Verbindung eine elektrische Verbindung zwischen Messwerk 1 und Trägerplatte 17 hergestellt.

Wie in Fig. 5 dargestellt, ist der Innendurchmesser der Durchkontaktierung bzw. der Kontaktausnehmung 25 geringfügig kleiner als der maximale Außendurchmesser (entspricht der Diagonalen) des Kontaktstiftes 15 ausgebildet.

Hierdurch ergibt sich bei eingesetztem Kontaktstift 15 ein gasdichter Presssitz.

Dieser Presssitz kann auch durch andere Profile von Kontaktstiften 15 mit flexiblen Einpresszonen und hierzu komplementären Profilen von Kontaktausnehmungen 25 gewährleistet werden. Denkbar sind hier Profile mit Ausnehmungen, so dass sich im Wesentlichen U-förmige, V-förmige, T-förmige usw. Profile für Kontaktstifte 15 und entsprechend komplementäre Profile für die Kontaktausnehmungen 25 ergeben können.

Selbstverständlich sind die Zahl und die Anordnung der am Außenumfang des Messwerkes 1 angeordneten Rastfedern 7, der Kontaktstifte 15 und der Zentrierbolzen 21 beliebig. In jedem Fall befinden sich ihre entsprechenden Aufnahmen - Ausnehmungen 19, Kontaktausnehmungen 25 und Zentrierlöcher 23 - in derselben Zahl und Anordnung auf der Trägerplatte 17.

## Patentansprüche

1. Messwerk (1) mit mehreren am Außenumfang des Messwerkes (1) angeordneten federnden Zungen,
die als Rastzungen (7) ausgebildet sind, welche in Ausnehmungen (19) einer Trägerplatte (17) einrastbar sind, sowie mit Kontaktmittel, die als aus der Unterseite des Messwerks (1) ragende Kontaktstifte (15) ausgebildet sind, welche in entsprechende Kontaktausnehmungen (25) der Trägerplatte (17) einsetzbar sind.

2. Messwerk nach Anspruch 1, **dadurch gekennzeichnet, dass** die Kontaktstifte (15) im Querschnitt quadratisch ausgebildet sind.

3. Messwerk nach Anspruch 1, **dadurch gekennzeichnet, dass** die Kontaktstifte (15) zumindest im Bereich der Kontaktierung flexible Einpresszonen mit Ausnehmungen im Profil aufweisen, die in entsprechenden Kontaktausnehmungen (25) mit hierzu komplementär ausgebildeten Profilen einsetzbar sind.

4. Messwerk nach einem der Ansprüche 1 bis 3, **dadurch gekennzeichnet, dass** die Kontaktstifte (15) gasdicht mit den Kontaktausnehmungen (25) verpressbar sind.

5. Messwerk nach einem der Ansprüche 1 bis 4, **dadurch gekennzeichnet, dass** die Kontaktstifte (15) verzinnt sind.

6. Messwerk nach einem der vorhergehenden Ansprüche, **dadurch gekennzeichnet, dass** am Messwerk (1) wenigstens ein Zentrierbolzen (21) angeordnet ist, der in eine entsprechende Zentrierausnehmung (25) in der Trägerplatte (17) einführbar ist.

7. Anordnung eines Messwerks (1) nach einem der vorhergehenden Ansprüche auf einer Trägerplatte (17), **dadurch gekennzeichnet, dass** die Trägerplatte (17) entsprechende Ausnehmungen (19) zur Aufnahme der Rastzungen (7) aufweist.

8. Anordnung nach Anspruch 7, **dadurch gekennzeichnet, dass** die Trägerplatte (17) zur Aufnahme der Kontaktstifte (15) entsprechende Kontaktausnehmungen (25) aufweist, die im Querschnitt rund ausgebildet sind.

9. Anordnung nach Anspruch 8, **dadurch gekennzeichnet, dass** die Kontaktausnehmungen (25) als Durchbrüche mit Durchkontaktierung ausgebildet sind.

10. Anordnung nach Anspruch 8 oder 9, **dadurch gekennzeichnet, dass** die Kontaktausnehmungen (25) mit einer Zinnlegierung ausgestattet sind.

11. Anordnung nach einem der Ansprüche 7 bis 10, **dadurch gekennzeichnet, dass** die Trägerplatte als Leiterplatte ausgebildet ist.

## Claims

1. Measuring mechanism (1) having a plurality of resilient tongues which are arranged on the outer circumference of the measuring mechanism (1) and are designed as latching tongues (7) which can be latched into recesses (19) in a support plate (17), and having contact means which are designed as contact pins (15) which protrude from the lower side of the measuring mechanism (1) and can be inserted into corresponding contact recesses (25) in the support plate (17).

2. Measuring mechanism according to Claim 1, **characterized in that** the contact pins (15) are of square design in cross section.

3. Measuring mechanism according to Claim 1, **characterized in that** the contact pins (15) have, at least in the region of the contact connection, flexible press-in zones having recesses in the profile which can be inserted into corresponding contact recesses (25) having profiles of complementary design thereto.

4. Measuring mechanism according to one of Claims 1 to 3, **characterized in that** the contact pins (15) can be pressed together with the contact recesses (25) in a gas-tight manner.

5. Measuring mechanism according to one of Claims 1 to 4, **characterized in that** the contact pins (15) are tin-coated.

6. Measuring mechanism according to one of the preceding claims, **characterized in that** at least one centring pin (21) is arranged on the measuring mechanism (1) and can be introduced into a corresponding centring recess (25) in the support plate (17).

7. Arrangement of a measuring mechanism (1) according to one of the preceding claims on a support plate (17), **characterized in that** the support plate (17) has corresponding recesses (19) for receiving the latching tongues (7).

8. Arrangement according to Claim 7, **characterized in that** the support plate (17) has, for receiving the contact pins (15), corresponding contact recesses (25) which are of round design in cross section.

9. Arrangement according to Claim 8, **characterized in that** the contact recesses (25) are designed as apertures having a through-plated contact connection.

10. Arrangement according to Claim 8 or 9, **characterized in that** the contact recesses (25) are provided with a tin alloy.

11. Arrangement according to one of Claims 7 to 10, **characterized in that** the support plate is designed as a printed circuit board.

## Revendications

1. Système de mesure (1) qui comporte plusieurs languettes élastiques disposées sur la périphérie extérieure du système de mesure (1) et agencées sous la forme de languettes (7) encliquetables dans des évidements (19) d'une plaque de support (17) et qui comporte des moyens de contact agencés sous la forme de tiges de contact (15), qui font saillie à partir de la face inférieure de l'unité de mesure (1) et qui peuvent être insérées dans des évidements de contact correspondants (25) de la plaque de support (17).

2. Système de mesure selon la revendication 1, **caractérisé en ce que** les tiges de contact (15) sont agencées avec une section transversale carrée.

3. Système de mesure selon la revendication 1, **caractérisé en ce que** les tiges de contact (15) possèdent, au moins dans la zone d'établissement du contact, des zones flexibles de serrage comportant un profil pourvu d'évidements et insérables dans des évidements correspondants de contact comportant des profils ayant une forme complémentaire du profil précédent.

4. Système de mesure selon l'une des revendications 1 à 3, **caractérisé en ce que** les tiges de contact (15) peuvent être comprimées d'une manière étanche aux gaz avec les évidements de contact (25).

5. Système de mesure selon l'une des revendications 1 à 4, **caractérisé en ce que** les tiges de contact (15) sont étamées.

6. Système de mesure selon l'une des revendications précédentes, **caractérisé en ce que** sur le système de mesure (1) est disposé au moins un boulon de centrage (21) qui peut être introduit dans une ouverture de centrage correspondante (25) formée dans la plaque de support (17).

7. Montage d'un système de mesure (1) selon les revendications précédentes sur une plaque de support (17), **caractérisé en ce que** la plaque de support (17) comporte des évidements correspondants (19) servant à loger des languettes d'encliquetage (17).

8. Montage selon la revendication 7, **caractérisé en ce que** la plaque de support (17) comporte, afin de loger les tiges de contact (15), des évidements de contact correspondants (25) qui ont une forme circulaire en coupe transversale.

9. Montage selon la revendication 8, **caractérisé en ce que** les évidements de contact (25) sont agencés sous la forme de passages traversants avec établissement d'un contact traversant.

10. Montage selon la revendication 8 ou 9, **caractérisé en ce que** les évidements de contact (25) sont pourvus d'un alliage à base d'étain.

11. Montage selon l'une des revendications 7 à 10, **caractérisé en ce que** la plaque de support est agencée sous la forme d'une plaquette à circuits imprimés.
